# EUROPEAN PATENT SPECIFICATION

(11) **EP 1 595 848 B1**
(45) Date of publication and mention of the grant of the patent: **08.08.2007**
(21) Application number: 04703937.5
(22) Date of filing: 21.01.2004
(51) Int. Cl.: C01G 51/00, C01G 1/00, H01B 13/00, H01L 39/12

(54) **SODIUM COBALT OXIDE HYDRATE**
NATRIUM-KOBALTOXID-HYDRAT
HYDRATE D'OXYDE DE SODIUM COBALT

(30) Priority: 27.01.2003 JP 2003017070
(43) Date of publication of application: 16.11.2005
(73) Proprietor: National Institute for Materials Science, Tsukuba-shi, Ibaraki 305-0047 (JP)
(72) Inventor: TAKADA, Kazunori, c/o Nat. Inst. Materials Science, Tsukuba-shi, Ibaraki 305-0047 (JP); SAKURAI, Hiroya, c/o Nat. Inst. Materials Science, Tsukuba-shi, Ibaraki 305-0047 (JP); MUROMACHI, Eiji, c/o Nat. Inst. Materials Science, Tsukuba-shi, Ibaraki 305-0047 (JP); SASAKI, Takayoshi, c/o Nat. Inst. Materials Sci., Tsukuba-shi, Ibaraki 305-0047 (JP)
(74) Representative: Röthinger, Rainer
(86) International application number: PCT/JP2004/000511
(87) International publication number: WO 2004/067450

(56) References cited:
- JP-A- 2001 320 095
- JP-A- 2002 274 943
- S. KIKKAWA, S. MYAZAKI, M. KOIZUMI: JOURNAL OF SOLID STATE CHEMISTRY, vol. 62, 1986, pages 35-39, XP002362792
- J.J. BRACONNIER, C. DELMAS, C. FOUASSIER, P. HAGEMULLER: "Comportement électrochimique des phases Nax CoO2" MATERIAL RESEARCH BULLETIN, vol. 15, 1980, pages 1797-1804, XP002362793
- PATENT ABSTRACTS OF JAPAN vol. 2003, no. 01, 14 January 2003 (2003-01-14) & JP 2002 274943 A (TOHOKU TECHNO ARCH CO LTD), 25 September 2002 (2002-09-25)
- PATENT ABSTRACTS OF JAPAN vol. 2002, no. 03, 3 April 2002 (2002-04-03) & JP 2001 320095 A (TOHOKU TECHNO ARCH CO LTD), 16 November 2001 (2001-11-16)
- K. TAKADA, H. SAKURAI, E. TAKAYAMA-MUROMACHI, F. IZUMI, R.A. DILLANIAN, T. SASAKI: NATURE, vol. 422, 2003, pages 53-55, XP002362794

## Description

### TECHNICAL FIELD

The present invention relates to a hydrated sodium-cobalt oxide exhibiting superconductivity.

### BACKGROUND ART

As a sodium-cobalt oxide comprising a CoO₂ layer wherein CoO₆ octahedra each having a cobalt atom coordinated with six oxygen atoms are linked in an edge-sharing manner, α-type (rhombohedral system), α'-type (monoclinic system), β-type (orthorhombic system) and γ-type (hexagonal system) were found in 1973 (see Non-Patent Publication 1). This publication reports that these systems have a crystal structure formed of cobalt - oxygen - sodium - oxygen - cobalt layers laminated in this order, and a distance between the adjacent cobalt layers (cobalt interlayer distance) of 5.19 Å, 5.38 Å, 5.51 Å and 5.44 Å, respectively.

It is also known that a change in cobalt interlayer distance is caused by deintercalation or intercalation of sodium ions from/to the above sodium-cobalt oxides. For example, sodium-cobalt oxides of NaₓCoO₂ (x =0.82, 0.90, 0.95) obtained in this way have cobalt interlayer distances of 5.52 Å, 5.51 Å and 5.38 Å, respectively (see Non-Patent Publication 2), and sodium-cobalt oxides of NaₓCoO₂ (x =0.5, 0.6) have cobalt interlayer distances of 5.51 Å and 5.56 Å, respectively (see Non-Patent Publication 3). As above, the cobalt interlayer distance in the known layer-structured sodium-cobalt oxides is in the range of 5Å to 6 Å.

Theretofore, great interest has been industrially shown in the following characteristics of sodium-cobalt oxides: (1) extremely large thermoelectric power and (2) potential ability as a precursor for synthesizing a lithium-cobalt oxide.

As to thermoelectric effect, since a large thermoelectromotive force was found in a NaCo₂O₄ single crystal in 1997 (see Non-Patent Publication 4), sodium-cobalt oxides have been regarded as one of noteworthy thermoelectric materials, and a previously reported material includes (Na, Ca) Co₂O₄ (see Non-Patent Publication 5) and NaCo₂₋ₓCuₓO₄ (see Non-Patent Publication 6).

A lithium-cobalt oxide represented by LiCoO₂ is currently use as an active material for a positive electrode in lithium-ion secondary batteries. This oxide has the same CoO₂ layer as that of the aforementioned sodium-cobalt oxides. A sodium-cobalt oxide used as a precursor for substituting a sodium ion residing between CoO₂ layers with a lithium ion makes it possible to obtain a lithium-cobalt oxide having a layer structure laminated in a different manner as compared to that to be obtained through a conventional solid-phase reaction process (see Non-Patent Publication 7). It has been disclosed that such a lithium-cobalt oxide can also be used as a material for a positive electrode in lithium-ion secondary batteries (see Non-Patent Publication 8).

Non-Patent Publication 1: C. Fouassier, G Matejka, J. -M. Reau, and P. Hagenmuller, J. Solid State Chem., 6, pp. 532-537 (1973)

Non-Patent Publication 2: J. -J. Braconnier, C. Delmas, C. Fouassier, and P. Hagenmuller, Mat. Res. Bull., 15, pp. 1797-1804 (1980)

Non-Patent Publication 3: S. Kikkawa, S. Miyazaki, and M. Koizumi, J. Solid State Chem., 62, pp. 35-39 (1986)

Non-Patent Publication 4: I. Terasaki, Y Sasago, and K. Uchinokura, Phys. Rev. B 56, pp. R12685-R12687

Non-Patent Publication 5: Y. Ando, N. Miyamoto, K. Segawa, and I. Terasaki, Phys. Rev. B 60, pp. 10580-10583 (1999)

Non-Patent Publication 6: I. Terasaki, Y Ishii, D. Tanaka, K. Takahashi, and Y Iguchi, Jpn. J. Appl. Phys. 40, pp. L65-L67 (2001)

Non-Patent Publication 7: C. Delmas, J. -J. Braconnier, and P. Hagenmuller, Mat. Res. Bull., 17, pp. 117-123 (1982)

Non-Patent Publication 8: J. M. Paulsen, J. R. Muller-Neuhaus, and J. R. Dahn, J. Electrochem. Soc., 147, pp. 508-516 (2000)

### DISCLOSURE OF INVENTION

In view of the above circumstance, it is an object of the present invention to provide a sodium-cobalt oxide having a cobalt interlayer distance of 9.5 Å to 10.5 Å which is significantly different from that of the known compounds, and exhibiting superconductivity at low temperature based on characteristics induced by the cobalt interlayer distance.

In order to achieve the object, the present invention provides a hydrated sodium-cobalt oxide comprising a plurality of CoO₂ layers each having edge-sharing CoO₆ octahedra, and a combination of two water molecule layers and a single sodium ion layer, which is interposed between the adjacent CoO₂ layers.

Preferably, the distance between the adjacent CoO₂ layers is in the range of 9.5 to 10.5 Å.

The present invention also provides a hydrated sodium-cobalt oxide, which is represented by the following general formula: NaₓCoO₂ · yH₂O, wherein 0 < x ≤ 0.4, and 1. 0 ≤ y ≤ 2.0.

Furthermore, the present invention also provides a method of producing a hydrated sodium-cobalt oxide, comprising; synthesizing, from a sodium compound and a cobalt compound, NaₓCoO₂ which comprises a plurality of CoO₂ layers each having edge-sharing CoO₆ octahedra, and a single sodium ion layer interposed between the adjacent CoO₂ layers; deintercalating a part of the sodium ions from said NₓCoO₂; and then intercalating a water molecule between the adjacent CoO₂ layers.

### BRIEF DESCRIPTION OF DRAWINGS

FIG 1 is a schematic diagram showing a crystal structure model of a parent compound Na_{0.7}CoO₂ and a hydrated sodium-cobalt oxide, in Inventive Example 1.
FIG 2 is a graph showing a powder X-ray diffraction pattern and a Rietveld analysis result of the hydrated sodium-cobalt oxide in Inventive Example 1.
FIG. 3 is a graph showing a measurement result about electrical resistance of the hydrated sodium-cobalt oxide in Inventive Example 1.
FIG. 4 is a graph showing a measurement result about magnetic susceptibility of the hydrated sodium-cobalt oxide in Inventive Example 1.
FIG 5 is a graph showing a powder X-ray diffraction pattern and a Rietveld analysis result of a product obtained in Comparative Example 1.
FIG. 6 is a graph showing a measurement result about magnetic susceptibility of the product obtained in Comparative Example 1 (•) and the hydrated sodium-cobalt oxide obtained in Inventive Example 1 (o).
FIG. 7 is a graph showing a powder X-ray diffraction pattern of a product obtained in Comparative Example 2.
FIG 8 is a graph showing a measurement result about magnetic susceptibility of the product obtained in Comparative Example 2 (•) and the hydrated sodium-cobalt oxide obtained in Inventive Example 1(o).

### BEST MODE FOR CARRYING OUT THE INVENTION

A hydrated sodium-cobalt oxide of the present invention is obtained by deintercalating, from a parent compound NaₓCoO₂, a part of the sodium ions residing between CoO₂ layers, and then intercalating water molecules between the CoO₂ layers.

For example, even if the parent compound NaₓCoO₂ is simply immersed in water, it is difficult to intercalate water molecules between the layersThe partial deintercalation of the interlayer sodium ions makes it possible to achieve this intercalation. Supposedly, the reason is that, as the result as the partial deintercalation of the sodium ions, a number of vacant sites capable of intercalating water molecules therein are formed around the remaining sodium ions, and the charge between the CoO₂ layers gets close to neutral so as to reduce an electrostatic interaction (electrostatic attraction force) between CoO₂ layer-Na layer-CoO₂ layer to facilitate increase in interlayer distance, whereby water molecules are intercalated, and the distance between the CoO₂ layers is increased.

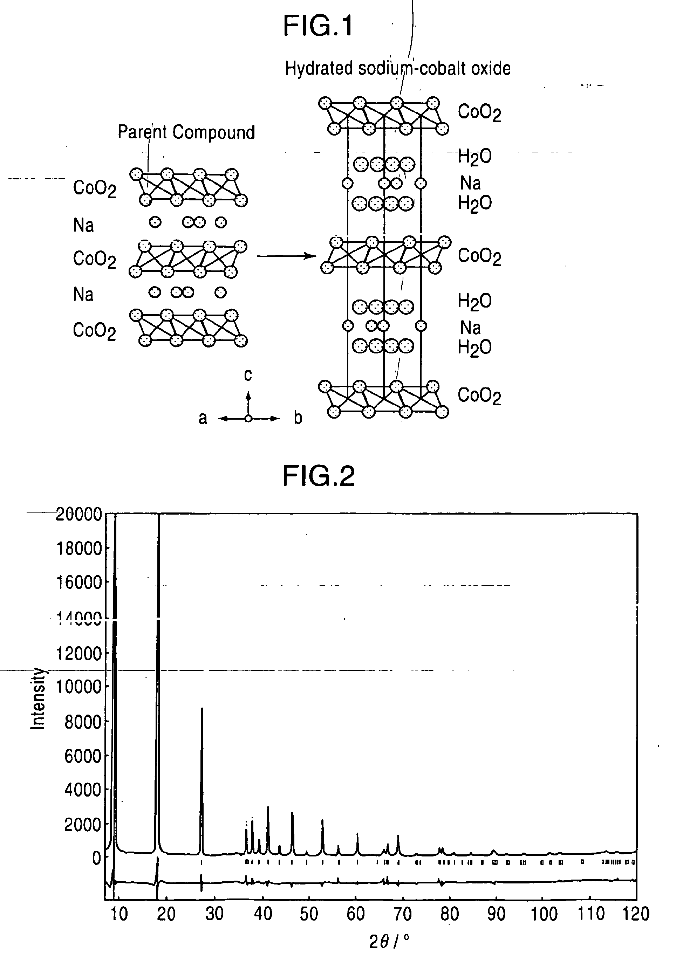

The hydrated sodium-cobalt oxide obtained in this way has a previously unknown structure in which a single sodium ion layer and two water molecule layers are interposed between the CoO₂ layers as shown in FIG 1, and the cobalt interlayer distance is increased up to about 9.8 Å.

In this hydrated sodium-cobalt oxide, the distance between the CoO₂ layers is largely increased, and the CoO₂ layers are laminated while interposing a combination of the sodium ion layer and the water molecule layers therebetween, which leads to a significant low interlayer interaction. Thus, conduction electrons are confined within an extremely limited 2-dimensional space of each CoO₂ layer, and thereby the inter-electron interaction in the CoO₂ layer becomes significantly stronger to provide superconductivity.

The parent compound NaₓCoO₂ may be synthesized by a convention process comprising mixing a sodium source and a cobalt source, and heating the mixture in an oxygen-containing atmosphere. This conventional process may include a process using sodium peroxide (Na₂O₂) and cobalt oxide (Co₃O₄) (Process 1: see the aforementioned Non-Patent Publication 1), a process using sodium oxide (Na₂O) and cobalt oxide (Co₃O₄) (see "A. Stoklosa, J. Molenda, and D. Than, Solid Srate Ionics, 15, pp. 211-216 (1985)), and a process using sodium carbonate (Na₂CO₃) and cobalt carbonate (CoCO₃) (Process 2: R. J. Balsys and R. L. Davis, Solid State Ionics, 93, pp. 279-282 (1996)); These processes may be used independently or in combination as a process for synthesizing the NaₓCoO₂.

In the parent compound NaₓCoO₂, a preferable range (x) of the sodium composition is 0.5 < x ≤ 1.0. If the sodium composition is less than the lower limit of this range, the cobalt oxide is liable to remain. If the sodium composition is greater than the upper limit of this range, Na₄CoO₄ is liable to be mixed as an impurity.

While the NaₓCoO₂ obtained in the way exhibits various crystal structures disclosed, for example, in the aforementioned Non-Patent Publication 1, its crystal structure fundamentally comprises CoO₂ layers each having edge-sharing CoO₆ octahedra, and a single sodium ion layer interposed between the CoO₂ layers, wherein a cobalt interlayer distance is in the range of 5 Å to 6 Å.

The deintercalation of sodium ions from the parent compound may be performed through a conventional process, for example, a chemical process using an oxidizing reagent, such as iodine or bromine (S. Kikkawa, and M. Kolzumi, Synthetic Met. 6, pp. 211-217 (1983)), or a process based on electrochemical oxidation (J. J. Braconnier, C. Delmas, C. Fouassier, and P. Hagenmuller, Mat. Bull., 15, pp. 1797-1804 (1980)).

The intercalation of water molecules may be performed in the most simplified manner through a process comprising immersing in water the above compound whose sodium ions have been partly deintercalated. Alternatively, it mat be a process comprising exposing the compound to a humid atmosphere.

A hydrated sodium-cobalt oxide to be obtained through the above method comprises a plurality of CoO₂ layers each having approximately the edge-sharing CoO₆ octahedra as those of the parent compound, and a combination of two water layers and a single sodium ion layer, which is interposed between the adjacent CoO₂ layers, wherein the distance between the adjacent CoO₂ layers is in the range of 9.5 to 10.5 Å.

The number of water molecules intercalated between the CoO₂ layers is varied depending on humidity. Specifically, the intercalation of water molecules is induced by exposing the hydrated sodium-cobalt oxide to a high-humidity atmosphere. By contrast, the deintercalation is induced by exposing the hydrated sodium-cobalt oxide to a low-humidity atmosphere. Each of Co atoms has two sites to be occupied by water molecules (in the after-mentioned structural analysis, water molecules are allocated to six sites residing in each Co atom illustrated in FIG 1 because water molecules actually diffuse between the CoO₂ layers). Thus, the number of water molecules to be intercalated between the CoO₂ layers is two at a maximum. Further, if the number of interlayer water molecules is reduced, the molecules cannot form a two-layer structure, and will simply occupy vacant sites in the sodium layers. Therefore, in the hydrated sodium-cobalt oxide of the present invention, the number of water molecules is between one and per Co atom. That is, in a general formula: NaₓCoO₂ **·** yH₂O representing the hydrated sodium-cobalt oxide, this relation is expressed by 0 < x ≤ 0.4, and 1. 0 ≤ y ≤ 2.0.

### (EXAMPLE)

The present invention will be described in detail in connection with the following examples.

### (Inventive Example 1)

In this example, a sodium-cobalt oxide expressed by Na_{0.7}CoO₂ was synthesized. After deintercalating a part of sodium ions using bromine, water molecules were intercalated between CoO₂ layers to prepare a hydrated sodium-cobalt oxide expressed by NaₓCoO₂ · yH₂O.

In the synthesis of the Na_{0.7}CoO₂, sodium carbonate (Na₂CO₃) and cobalt oxide (Co₃O₄) were used as a starting material. These starting materials were weighted and mixed together to satisfy the relationship: [Na]/[Co] = 0.7/1.0, and the obtained mixture was pelletized through an uniaxial pressing process. The obtained pellets were heated at 800°C in an oxygen flow for 8 hours to obtain the Na_{0.7}CoO₂. According to the analysis by powder X-ray diffractometry, it was verified that the obtained compound has the same crystal structure as that disclosed in the aforementioned Process 2. Specifically, the compound had a lattice constant a = 2.8281 (3) and c = 10.9658 (11) Å. That is, a cobalt interlayer distance was about 5.48 Å.

The deintercalation of sodium ions from the obtained Na_{0.7}CoO₂, and the intercalation of water molecules therein were performed through the following process. The synthesized Na_{0.7}CoO₂ was firstly crushed and weighted. With respect to the amount of sodium in the weighted Na_{0.7}CoO₂ powder, 5 parts of bromine was dissolved in acetonitrile to prepare an acetonitrile solution of bromine. Then, the Na_{0.7}CoO₂ powder was immersed in this solution, and left at room temperature for 5 days to deintercalate a part of sodium ions from between the Na_{0.7}CoO₂ layer. The obtained power was filtered and cleaned to remove unreacted bromine using acetonitrile, and then immersed in distilled water to intercalate water molecules between the CoO₂ layers.

For determining the composition of the hydrated sodium-cobalt oxide obtained in this way, the respective contents of sodium and cobalt were measured by inductively-coupled plasma atomic emission spectrometry (ICP-AES). As a result, it was proven that this oxide has a composition of Na_{0.35}CoO₂ · 1.3H₂O.

Based on the result of the powder X-ray diffractometry, the structure of this hydrated sodium-cobalt oxide was refined through a Rietveld refinement method using the same space group (P6₃/mmc) as that of the structure of the parent compound Na_{0.7}CoO₂. The result of the Rietveld analysis is shown in Table 1. A refined lattice constant was a = 2.8230 (2) Å and c = 19.6207 (14) Å, and structural parameters were as shown in Table 1. In Table 1, the refinement was performed on the assumption that the interlayer water moiecuies is WO having a scattering factor equal to the total of the scattering factors of one oxygen atom and two hydrogen atoms. Further, U indicates an isotopic atom displacement parameter, and the content of sodium was fixed at the result of the ICP-AES.

**Table 1**

| Atom | Site | Fractional Coordinate | | | | Occupancy | U/Å |
|---|---|---|---|---|---|---|---|
| | | x | | y | z | | |
| Co | 2a | 0 | | 0 | 0 | 1 | 0.0063 (6) |
| O | 4f | 1/3 | | 2/3 | 0.0451 (3) | 1 | 0.0162 (12) |
| Na1 | 2d | 2/3 | | 1/3 | 1/4 | 0.159 (4) | = U (O) |
| Na2 | 2b | 0 | | 0 | 1/4 | 0.192 | = U (O) |
| WO1 | 12k | 0.174 (13) | | = 2x (WO1) | 0.1793 (2) | 0.070 (12) | = U (O) |
| WO2 | 12k | 0.370(12) | | = x (W02)/2 | = z (WO1) | 0.176 (12) | = U (O) |

FIG 2 shows a powder X-ray diffraction pattern and a Rietveld analysis result of the hydrated sodium-cobalt oxide in Inventive Example 1. In FIG 2, the mark +: measurement value, the solid line: calculation value, the vertical bar: Bragg reflection position, and the lower solid line: the difference between the measurement and calculation values. The obtained R factors had low values, specifically, R_{B} = 2.84 % and R_{F}= 3.53 %. Further, as shown in FIG 2, the calculated diffraction pattern based on the structural model well corresponds to the actual measurement value. This proves that this structural model is adequate as the crystal structure of the hydrated sodium-cobalt oxide obtained in Inventive Example 1.

As evidenced by the above results, as shown in FIG 1, the obtained hydrated sodium-cobalt oxide comprises approximately the same CoO₂ layers as those of the parent structure, and a combination of a single sodium ion layer and two water molecule layers, which is intercalated between the CoO₂ layers, and has a cobalt interlayer distance of 9.81 Å, which is extremely long as compared with the parent structure.

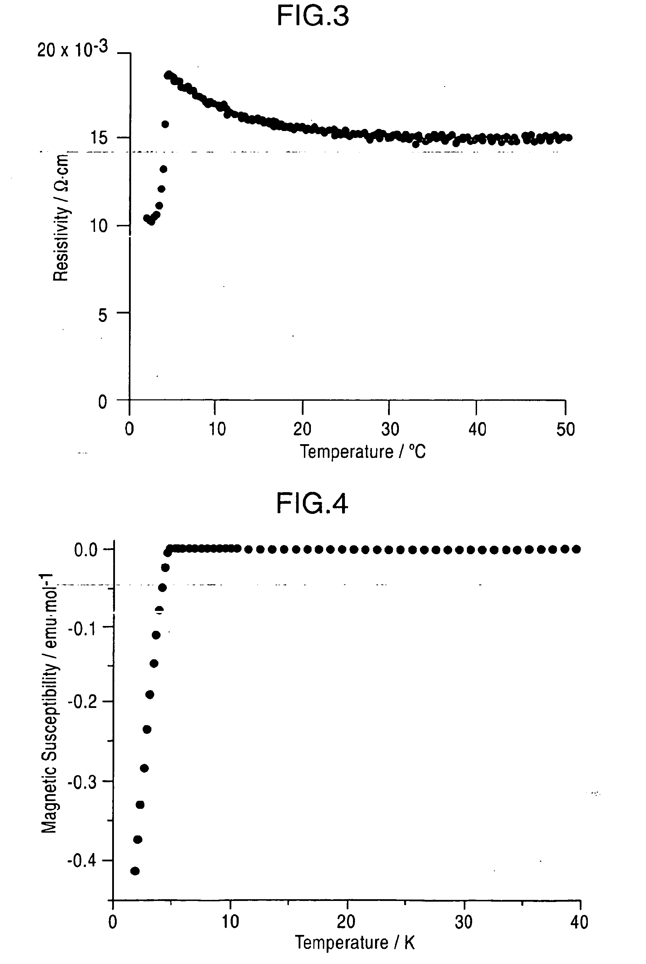

The superconductivity of the obtained hydrated sodium-cobalt oxide was checked by resistivity measurement using a four terminal method and magnetic-susceptibility measurement using a SQUID (Superconducting Quantum Interference Device). FIG 3 shows the result of the resistivity measurement in a zero magnetic filed. The hydrated sodium-cobalt oxide exhibited a sharp change of resistivity at about 5 K and fell off.

The magnetic-susceptibility measurement was performed under the conditions of a zero-field cooling in a temperature range of 2 K to room temperature, wherein a measurement magnetic field was set at 20 Oe. The result is shown in FIG. 4. This measurement value at 2K is equivalent to 13 % of a theoretical value (- 1/4 π emu/cm³) in perfect diamagnetism. Considering this result together with that of resistivity measurement, it was verified that this material exhibits superconductivity.

### (Comparative Example 1)

In this example, a hydrated sodium-cobalt oxide having no intercalated water molecule was synthesized, and its superconductivity characteristic was checked. The synthesis of the parent compound Na_{0.7}CoO₂ and the partial deintercalation of sodium ions were performed in the same manner as those in Inventive Example 1. Acetonitrile used as a solvent of bromine and for removing excessive bromine was removed by vaporization under reduced pressure.

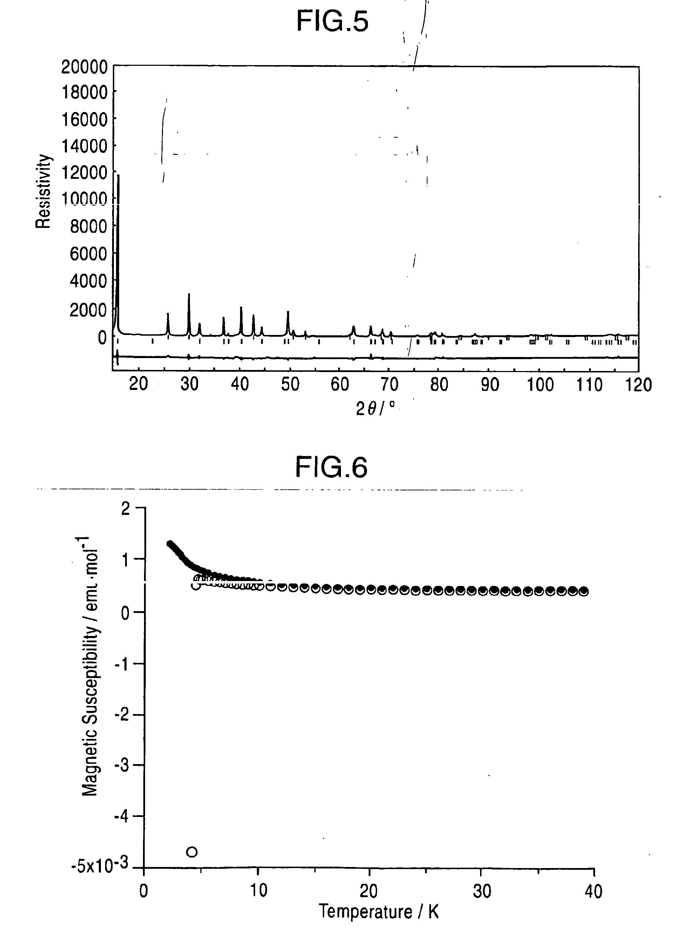

FIG. 5 shows a powder X-ray diffraction pattern of a compound obtained in this way. In FIG 5, the mark +: measurement value, the solid line: calculation value, the vertical bar (upper): Bragg reflection position corresponding to sodium bromide, the vertical bar (lower): Bragg reflection position corresponding to sodium-cobalt oxide, and the lower solid line: the difference between the measurement and calculation values. As a result, it was proven that the obtained material is a mixture of a sodium-cobalt oxide having approximately the same crystal structure (space group: P6₃/mmc, a = 2.8184 (4) Å, c = 11.1532 (13) Å) as that of the parent compound, and sodium bromide.

FIG 6 shows a measurement result about magnetic susceptibility of this mixture using a SQUID, wherein the vertical axis represents magnetic susceptibility per Co atom residing in the mixture. In this mixture, no decrease in magnetic susceptibility was observed in a temperature of 2 K or more, and no superconducting phase was created.

### (Comparative Example 2)

in this example, a part of water molecules in the hydrated sodium-cobalt oxide obtained in Inventive Example 1 was deintercalated to synthesize a sodium-cobalt oxide having a single water molecule layers, and its superconductive characteristic was checked. The partial deintercalation of water molecules was performed by exposing the hydrated sodium-cobalt oxide obtained in Inventive Example 1, to a nitrogen flow for one week.

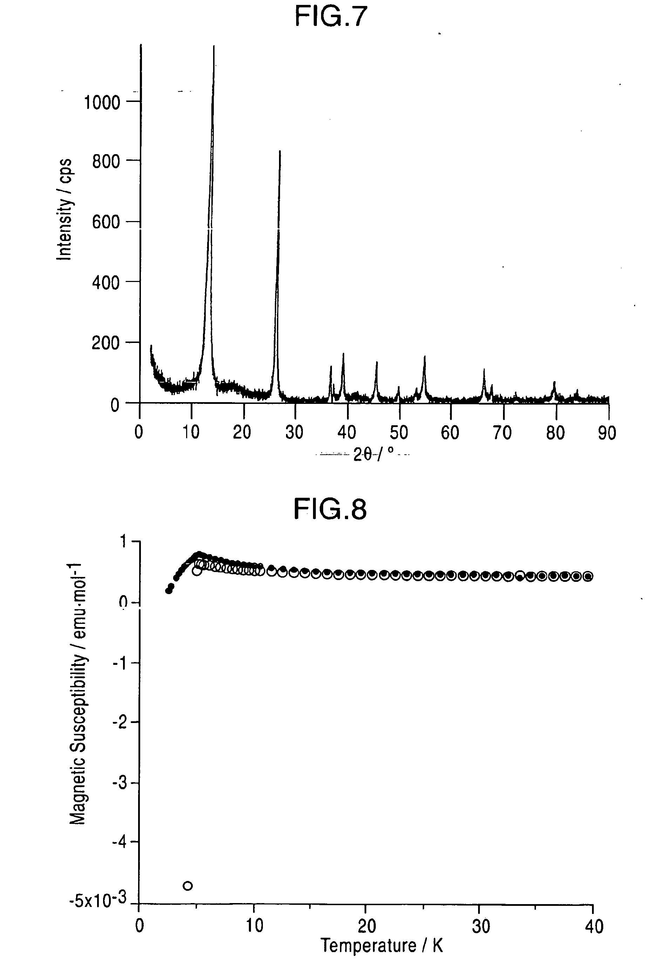

A powder X-ray diffraction pattern of the obtained material is shown in FIG. 7. The resulting diffraction peak can be indexed using the unit cell of a hexagonal system as with the hydrated sodium-cobalt oxide obtained in Inventive Example 1. A lattice constant calculated based on this unit lattice was a = 2. 8301 (12) Å, and c = 13.834 (6) Å.

That is, the distance between the CoO₂ layers is about 7 Å. Thus, this structure would have only one water molecule layer between the CoO₂ layers.

A measurement result about magnetic susceptibility of this mixture using a SQUID is shown in FIG. 8. In this mixture, while some decrease in magnetic susceptibility was observed from around 5 K, the magnetic susceptibility did not have a negative value even if the temperature was reduced to 2 K. The decrease in magnetic susceptibility corresponds to the characteristic at a transition temperature to a superconducting phase in the hydrated sodium-cobalt oxide obtained in Inventive Example 1. Thus, it is believed that this decrease is induced by the remaining portion of the hydrated sodium-cobalt oxide obtained in Inventive Example 1.

In this connection, no existence of the remaining phase was observed by the powder X-ray diffractometry, because this remaining amount was an extremely small value according to the calculation based on the decrease in magnetic susceptibility (1 x 10⁻³ emu/mol) observed in Comparative Example 2, and the decrease in magnetic susceptibility (4 x 10⁻³ emu/mol) observed in Inventive Example 1.

### INDUSTRIAL APPLICABILITY

The hydrated sodium-cobalt oxide of the present invention has an extremely wide interlayer distance increased to about 9.8 Å, and includes highly diffusible sodium ions and water molecules between the layers. Thus, based on high ability of ion-exchanging with various ion species and molecules, the hydrated sodium-cobalt oxide can be effectively used as a precursor for synthesizing compounds through ion exchanging. In addition, this hydrated sodium-cobalt oxide is the first cobalt oxide exhibiting superconductivity. Thus, the synthesis of various compounds using this material as a precursor is significant valuable in researches on new superconducting materials.

## Claims

1. A hydrated sodium-cobalt oxide which exibits superconductivity at a temperature of 5 k or less comprising a plurality of CoO₂ layers each having edge-sharing CoO₆ octahedra, and a combination of two water molecule layers and a single sodium ion layer, which is interposed between the adjacent CoO₂ layers.

2. The hydrated sodium-cobalt oxide as defined in claim 1, wherein the distance between the adjacent CoO₂ layers is in the range of 9.5 to 10.5 Å.

3. The hydrated sodium-cobalt oxide as defined in claim 1, which is represented by the following general formula: NaₓCoO₂ **·** yH₂O, wherein 0 < x ≤ 0.4, and 1.0 ≤ y ≤ 2.0.

4. A method of producing a hydrated sodium-cobalt oxide which exibits superconductivity at a temperature of 5 k or less, comprising:
synthesizing, from a sodium compound and a cobalt compound, NaₓCoO₂, wherein 0.5 ≤ x ≤ 1.0, which comprises a plurality of CoO₂ layers each having edge-sharing CoO₆ octahedra, and a single sodium ion layer interposed between the adjacent CoO₂ layers;
deintercalating a part of the sodium ions from said NaₓCoO₂; and then
intercalating a water molecule between the adjacent CoO₂ layers.

## Patentansprüche

1. Natriumkobaltoxidhydrat, das bei einer Temperatur von 5 K oder weniger Supraleitfähigkeit aufweist, umfassend eine Vielzahl von CoO₂-Schichten, die jeweils kantenverknüpfte CoO₆-Oktaeder aufweisen, und eine Kombination von zwei Wassermolekülschichten und einer einzelnen Natriumionenschicht, die zwischen die benachbarten CoO₂-Schichten eingeschoben ist.

2. Natriumkobaltoxidhydrat nach Anspruch 1, wobei der Abstand zwischen den benachbarten CoO₂-Schichten im Bereich von 9,5 bis 10,5 Å liegt.

3. Natriumkobaltoxidhydrat nach Anspruch 1, das durch die folgende allgemeine Formel dargestellt ist: NaₓCoO₂ **·** yH₂O, wobei 0 < x ≤ 0,4 und 1,0 ≤ y ≤ 2,0.

4. Verfahren zur Herstellung eines Natriumkobaltoxidhydrats, das bei einer Temperatur von 5 K oder weniger Supraleitfähigkeit aufweist, umfassend:
Synthetisieren von NaₓCoO₂ aus einer Natriumverbindung und einer Kobaltverbindung, wobei 0,5 ≤ x ≤ 1,0, das eine Vielzahl von CoO₂-Schichten, die jeweils kantenverknüpfte CoO₆-Oktaeder aufweisen, und eine einzelne zwischen die benachbarten CoO₂-Schichten eingeschobene Natriumionenschicht umfasst;
Deinterkalieren eines Teils der Natriumionen aus dem NaₓCoO₂; und anschließendes
Interkalieren eines Wassermoleküls zwischen die benachbarten CoO₂-Schichten.

## Revendications

1. Oxyde de sodium-cobalt hydraté qui montre une superconductivité à une température de 5°K ou moins comprenant une pluralité de couches de CoO₂ ayant chacune des octaèdres de CoO₆ partageant des arêtes, et une combinaison de deux couches de molécules d'eau et une couche unique d'ions sodium, qui est interposée entre les couches de CoO₂ adjacentes.

2. Oxyde de sodium-cobalt hydraté selon la revendication 1, dans lequel la distance entre les couches de CoO₂ adjacentes est dans la plage de 9,5 à 10,5 Å.

3. Oxyde de sodium-cobalt hydraté selon la revendication 1, qui est représenté par la formule générale suivante : NaₓCoO₂ · yH₂O, dans laquelle 0 < x ≤ 0,4, et 1,0 ≤ y ≤ 2,0.

4. Procédé de production d'un oxyde de sodium-cobalt hydraté qui montre une superconductivité à une température de 5°K ou moins comprenant :
de synthétiser, à partir d'un composé de sodium et d'un composé de cobalt, NaxCoO₂, où 0,5 ≤ x ≤ 1,0, qui comprend une pluralité de couches de CoO₂ ayant chacune des octaèdres de CoO₆ partageant des arêtes, et une couche unique d'ions sodium interposée entre les couches de CoO₂ adjacentes ;
de désintercaler une partie des ions sodium dudit NaₓCoO₂ ; et ensuite
d'intercaler une molécule d'eau entre les couches de CoO₂ adjacentes.
